Europäisches Patentamt

European Patent Office

Office européen des brevets

(11) Publication number: **0 035 894**
**B1**

(12) **EUROPEAN PATENT SPECIFICATION**

(45) Date of publication of patent specification: **25.06.86**

(21) Application number: **81300957.8**

(22) Date of filing: **06.03.81**

(51) Int. Cl.⁴: **G 11 B 5/84, H 01 F 41/14**

(54) **Process for producing a magnetic recording medium.**

(30) Priority: **10.03.80 JP 30807/80**

(43) Date of publication of application:
**16.09.81 Bulletin 81/37**

(45) Publication of the grant of the patent:
**25.06.86 Bulletin 86/26**

(84) Designated Contracting States:
**DE FR GB IT NL**

(56) References cited:
**DE-A-2 435 887**
**DE-A-2 547 552**
**FR-A-2 376 485**
**GB-A-1 493 088**

**FUNKSCHAU, Vol.51, No.14, July 1979,
München, "Magnetbänder mit aufgedampfter
Schicht", page 11.**

**Patents Abstracts of Japan, Vol.3, No.41, 10
April 1979, page 120E103.**

**Patents Abstracts of Japan, Vol.3, No.40, 6
April 1979, page 95E102.**

(73) Proprietor: **SEKISUI KAGAKU KOGYO
KABUSHIKI KAISHA
4-4 Nishitenma 2-chome Kita-ku
Osaka shi Osaka (JP)**

(72) Inventor: **Nakata, Shinsaku
6-15, Hattoriminami-machi 4-chome
Toyonaka-shi Osaka-fu (JP)**
Inventor: **Mikami, Yoichi
1-28, Ohenishishinbayashi-machi 3-chome
Nishigyo-ku Kyoto-shi Kyoto-fu (JP)**
Inventor: **Fukaya, Kazuhiro
11-1, Tomooka 3-chome
Nagaokakyo-shi Kyoto-fu (JP)**
Inventor: **Hotta, Masahiro
7-1-1001, Honjyo Higashi 3-chome
Ohyodo-ku Osaka-shi Osaka-fu (JP)**

(74) Representative: **Myerscough, Philip Boyd et al
J.A.Kemp & Co. 14, South Square Gray's Inn
London, WC1R 5EU (GB)**

Courier Press, Leamington Spa, England.

**Description**

This invention relates to a process for producing magnetic recording media such as magnetic tapes, magnetic discs and magnetic drums by an ion plating method in a high vacuum.

There have been widely used magnetic recording media obtained by coating a dispersion of a ferromagnetic powder such as a gamma-iron oxide powder, a chromium oxide powder or a ferromagnetic metal powder in a resinous binder on a non-magnetic substrate made of such a material as polyethylene terephthalate or aluminum. Various improvements have been suggested in recent years on this type of magnetic recording media in order to meet the requirement for high-density recording. However, there is a theoretical limit to the increasing of recording density in this type of magnetic recording media because the ferromagnetic material used is in the form of a powder and the reduction attainable of its particle diameter is limited. More recently, magnetic recording media having a magnetic layer composed solely of a ferromagnetic material in thin film form (vapour deposited type) have been energetically investigated and developed using such film-forming methods as wet plating, vacuum deposition, sputtering and ion plating in an attempt to obtain a striking increase in recording density, and some of such recording media have already gained commercial acceptance. In practice, however, these magnetic recording media have their own defects, and there is still room for further improvement.

For example, because thin-film type magnetic recording media formed by wet plating or vacuum deposition have a very low adhesion strength between the magnetic layer and the substrate, they have the defect that the magnetic layer tends to be peeled, worn or otherwise damaged by mechanical fricton (namely, by contact with the magnetic head) during recording and playback.

GB—A—1493088 discloses an ionized cluster beam deposition method for the formation of thin metallic coatings on an insulating base material. To form the cluster, metal vapour is released as a jet through a small hole in the top of a heated crucible (hole diameter from 1 to 30%, preferably 5 to 20%, of the inner diameter of the crucible). The cluster thus formed is ionized by collision with electrons generated by applying a DC voltage between an ionizing heater and an ionizing anode, and the ionized cluster is accelerated by applying a DC voltage between the ionizing anode and an extraction electrode and an electrode placed behind the base material.

Thin film-type magnetic recording media formed by sputtering and the conventional ion plating methods (for example, as disclosed in JP—A—50—33807 and JP—A—50—99703 and FR—A—2376485) have an improved adhesion strength between the magnetic layer and the substrate. Since, however, film formation by these methods relies on the utilization of glow discharge or plasma, the inclusion of residual gases and impurities adversely affects the crystallinity of the ferromagnetic film layer, and the resulting magnetic recording medium has defective magnetic characteristics typified by reduced squareness ratios. Owing to the non-uniformity of a discharge condition, the magnetic recording media obtained by these methods vary in film quality and magnetic characteristics. Accordingly, they still have problems to be solved when they are intended for high-performance and high-density recording.

It is an object of this invention therefore to provide a magnetic recording medium having a ferromagnetic film layer which has magnetic characteristics suitable for high-density recording (that is to say, having a high coercivity and a squareness ratio of near 1) and possesses good resistance to peeling or damage by contact with a magnetic head.

We have now found that the above object of the invention can be achieved by a magnetic recording medium having a ferromagnetic film formed by an ion plating method in a high vacuum without using glow discharge or plasma as in FR—A—2376485.

Thus, according to this invention, there is provided a process for producing a magnetic recording medium by ion-plating a non-magnetic substrate with ions of a ferromagnetic material obtained by heating an open crucible (that is a crucible the opening to which is not substantially less than the inner diameter of the crucible) containing the ferro-magnetic material in a high vacuum thereby vaporizing the ferromagnetic material, ionizing the vapour particles by impinging accelerated electrons from an electron radiation source onto the vapour particles and impinging the ionized vapour particles onto (the substrate to form a ferromagnetic thin film thereon, characterized by employing a pressure of $1.33 \times 10^{-3}$ to $1.33 \times 10^{-4}$ Pa ($1 \times 10^{-5}$ to $1 \times 10^{-6}$ torr), ionizing the vapour particles by impinging onto them electrons from a heated filament, which electrons have been accelerated by applying a magnetic DC voltage to said filament and a guard and grounding a mesh electrode, accelerating the resulting ionized vapour particles in an electric field formed by applying a negative DC voltage to an ion-accelerating electrode positioned behind the substrate and impinging the accelerated ionized vapour particles onto the substrate at an angle of incidence of above 30° with respect to the perpendicular to the substrate.

Embodiments of the invention are defined in claims 2 to 6.

In the present invention, the ferromagnetic material for forming the magnetic layer (ferromagnetic thin film) is preferably composed of an element such as iron, cobalt or nickel, an alloy containing at least one such element, or a mixture of such an element with another element.

Examples of iron alloys are alloys of iron with cobalt, nickel, manganese, chromium, copper, gold or titanium. Examples of cobalt alloys are alloys of cobalt with phosphorus, chromium, copper, nickel, manganese, gold, titanium, yttrium, samarium or bismuth. Examples of nickel alloys are alloys of nickel with copper, zinc or manganese.

The other element mentioned above includes, for example, phosphorus, chromium, copper, zinc, gold, titanium, yttrium, samarium and bismuth.

The thickness of the magnetic layer, i.e. the ferromagnetic thin film, is preferably 20 to 5000 nm, especially preferably 50 to 500 nm.

Examples of the non-magnetic material constituting the substrate used in this invention include polymeric materials such as polyvinyl chloride, polyvinyl fluoride, cellulose acetate, polyethylene terephthalate, polybutylene terephthalate, polyethylene, polypropylene, polycarbonate, polyimide, polyether sulfone and polyparabanic acid, non-magnetic metal materials such as copper and copper-zinc alloy, and ceramic materials such as sintered bodies, porcelains, ceramics and glass.

The shape of the substrate composed of the aforesaid non-magnetic material may be determined suitably according to the ultimate use of the resulting magnetic recording medium. It is, for example, in the form of a tape, film, disc, or drum.

According to the high-vacuum ion plating method of this invention, a ferromagnetic thin film is vapor-deposited on the substrate by the following steps.

(1) An open crucible containing a vapour source material capable of forming a ferromagnetic thin film is heated in a vacuum chamber evacuated to a high vacuum of $1.33\times10^{-3}$ to $1.33\times10^{-4}$ Pa ($1\times10^{-5}$ to $1\times10^{-6}$ torr) or lower by a heating means such as resistance heating, electron beam heating, electron bombardment heating or induction heating, thereby vaporizing the vapour source material.

(2) Thereafter, electrons released from an electron radiation source are accelerated in an electric field and impinged onto the vapour particles to ionize them.

(3) Next, the ionized vapour particles are accelerated by a field effect to impart a high energy thereto, and then impinged onto a substrate composed of a non-magnetic material at the desired incidence angle.

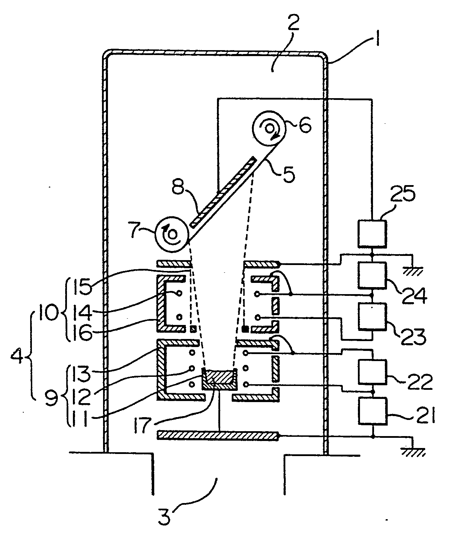

One preferred embodiment of the present invention is described below in detail with reference to the accompanying drawing which is a diagram showing an example of an apparatus for performing the process of this invention.

A vacuum chamber 2 in a vacuum vessel 1 is adapted to be evacuated to a high vacuum of $1.33\times10^{-3}$ to $1.33\times10^{-4}$ Pa ($1\times10^{-5}$ to $1\times10^{-6}$ torr) by means of an evacuating system (composed of an oil rotary pump, an oil diffusing pump, etc. but not shown) connected to an exhaust port 3. Within the vacuum chamber 2 are disposed an ion source 4 for deposition, a film-like substrate 5, a feed roll 6 for the film-like substrate, a wind-up roll 7 for the product (a roll driving device is not shown) and an ion accelerating electrode 8. The ion source 4 for deposition is constructed of a vapour generating section 9 and a vapour ionizing section 10. The vapour generating section 9 is comprised of an open crucible 11, a filament 12 for releasing hot electrons and a guard 13 for controlling the electric field. The vapour ionizing section 10 is comprised of a filament 14 for releasing hot electrons, a mesh electrode 15 for accelerating the released electrons in an electric field and a guard 16 for controlling the electric field. The drawing further shows power supplies 21 to 25 for energizing the present apparatus and an electric circuit therefor outside of the vacuum vessel 1.

The production of a magnetic recording medium in accordance with this invention using the above-described apparatus is described specifically.

First, as shown in the drawing, the non-magnetic substrate 5 such as a polyethylene terephthalate film is set on the feed roll 6 so that it is wound up on the wind-up roll 7.

A ferromagnetic material 17 capable of forming a ferromagnetic thin film is fed into the crucible 11 and the ion source 4 for deposition is set as shown in the drawing.

Then, the vacuum chamber 2 is evacuated to a high vacuum of $1.33\times10^{-3}$ to $1.33\times10^{-4}$ Pa ($1\times10^{-5}$ to $1\times10^{-6}$ torr) by the evacuating system through the exhaust port 3. At this time, it is preferred to wind and unwind the film-like non-magnetic substrate 5 in order to remove the matter adsorbed to the surface of the substrate 5 and the air entrained in the feed roll 6. When the degree of vacuum of the vacuum chamber 2 has reached a definite value, the power supplies 21 to 25 are turned on.

The crucible 11 is heated by passing a current through the filament 12 by the power supply 22 to heat it and release hot electrons, applying a negative DC voltage to the filament 12 and the guard 13 by means of the power supply 21, and grounding the crucible 11 thereby accelerating the released electrons in an electric field and bombarding the crucible 11. Preferably, the above operation is performed so that the accelerated electrons are also impinged onto the ferromagnetic material 17. The heated ferromagnetic material 17 vaporizes at a vapour pressure corresponding to the heating temperature, and the evaporated particles reach the vapour ionizing section 10.

In the vapour ionizing section 10, the vapour particles are ionized by passing a current through the filament 14 from the power supply 23 to heat them and release hot electrons, applying a negative DC voltage to the filament 14 and the guard 16 by means of the power supply 24, and grounding the mesh electrode 15 to accelerate the released electrons in an electric field thereby impinging the accelerated electrons against the vapour particles. Usually, up to 50%, preferably 1 to 20%, of the vapour particles are ionized.

Since the ionized vapour particles are in the positively charged state, they are accelerated by applying a negative DC voltage to the ion accelerating electrode 8 by the power supply 25, whereby a high kinetic energy is imparted thereto. Thus, the electrically accelerated vapour particle ions of the ferromagnetic material collide with the surface of the substrate 5 to form a thin film of the ferromagnetic material thereon.

Those vapour particles which have not been ionized (neutral particles) do not undergo acceleration by the electric field, and therefore, they are impinged onto, and deposited on, the surface of the substrate 5 at the speed imparted during the evaporation.

A ferromagnetic thin film having magnetic anisotropy in a specified direction can be formed if the accelerated vapour particle ions are impinged obliquely onto the substrate (namely, when they are impinged onto the substrate in a direction angularly displaced with respect to the perpendicular to the substrate). The oblique impingement may be performed by inclining the substrate (tape) toward the advancing direction with respect to the ion source 4 (the preferred incidence angle being 30 to 87° with respect to the perpendicular to the substrate), or by inclining the substrate (tape) in the widthwise direction with respect to the ion source 4 (the preferred incidence angle being 40 to 75° with respect to the perpendicular to the substrate).

The magnetic recording medium in accordance with this invention is produced as a result of the formation of such a ferromagnetic thin film on the substrate surface in the above manner. The magnetic recording medium so produced is then taken up on the wind-up roll 7.

In order to obtain a magnetic recording medium having better mechanical properties and magnetic characteristics by the process described above, it is preferred to apply an electron current of at least 30 mA for ionization of vapour particles, maintain the ion current density by the ionized vapour particles at 1 $\mu A/cm^2$ or higher.

In the production of the magnetic recording medium in accordance with this invention, sputtering of the material constituting the surface of the substrate, etching of the substrate surface and ion implantation including physical embedding of the sputtered substrate material particles and the vapour particles occur in the course of the impingement of accelerated ions onto the substrate. As a result, the adhesion strength between the resulting ferromagnetic thin film layer and the substrate increases, and a magnetic recording medium having excellent abrasion resistance and head crush resistance can be obtained.

Since the method of this invention is carried out in a high vacuum of $1.33 \times 10^{-3}$ to $1.33 \times 10^{-4}$ Pa ($1 \times 10^{-5}$ to $1 \times 10^{-6}$ torr), the present invention is free from the defects of the conventional ion plating method, that is, the inclusion of residual gases and impurities and the poor crystallinity of the magnetic film which are attributed to the fact that application of glow discharge or plasma for ionization has to be effected in a low vacuum for example of $1.33 \times 10^{-1}$ Pa ($10^{-3}$ torr). Accordingly, the method of this invention gives a magnetic recording medium having excellent magnetic characteristics, especially an improved squareness ratio.

The non-limitative Examples given below illustrates the present invention more specifically.

Examples 1 and 2

Ten grams of cobalt lumps (purity 99.99%) were charged into crucible 11 made of high-purity carbon using the high-vacuum ion plating apparatus shown in the attached drawing.

A 15 μm thick polyethylene terephthalate film was used as non-magnetic substrate 5. The feed roll 6 and wind-up roll 7 were arranged as shown in the drawing.

A ferromagnetic thin film of a ferromagnetic material was formed under the conditions shown in Table 1.

TABLE 1

| | | Example 1 | Example 2 |
|---|---|---|---|
| Vacuum conditions | Initial degree of vacuum Pa (torr) | $1.33 \times 10^{-4}$ ($1 \times 10^{-6}$) | $1.33 \times 10^{-3}$ ($1 \times 10^{-5}$) |
| | Degree of vacuum during deposition Pa (torr) | $1.33 \times 10^{-3}$ ($1 \times 10^{-5}$) | $2 \times 10^{-3}$ ($1.5 \times 10^{-5}$) |
| Conditions for heating the crucible | Current passed through the filament (A; Ac) | 28 | 25 |
| | Electron accelerating voltage (V) | 900 | 1,000 |
| | Electron current (mA) | 850 | 750 |
| | Crucible temperature (°C) | about 1,900 | about 1,900 |
| Conditions for ionization | Current passed through the filament (A; Ac) | 25 | 28 |
| | Electron accelerating voltage (V) | 400 | 600 |
| | Electron current (mA) | 100 | 200 |
| Conditions for ion acceleration | Accelerating voltage (V) | −2,500 | −1,000 |
| | Ion current (µA) | 500 | 550 |
| Roll driving speed (mm/min.) | | 10 | 10 |
| Incidence angle | | about 75° | about 80° |

The thickness of each of the ferromagnetic films (magnetic layers) of the resulting magnetic recording media, measured by a thickness gauge of the multiple-beam-interferometer type, was about 100 nm. The basic magnetic characteristics of the magnetic recording media were measured by a DC magnetization measuring instrument (BHH−50, a product of Riken Benshi Co., Ltd.). Both showed very good magnetic characteristics as demonstrated by the results given in Table 2 below.

TABLE 2

| Magnetic characteristics | Example 1 | Example 2 |
|---|---|---|
| Coercivity $\dfrac{10^3 \ A}{4\pi \ m}$ | 540 | 800 |
| Residual magnetic flux density $10^{-4}$ T | 8,500 | 11,000 |
| Squareness ratio | 0.92 | 0.95 |

The adhesion strength between the polyethylene terephthalate substrate and the ferromagnetic thin film in each of the resulting magnetic recording media was examined by a peel test using an adhesive regenerated cellulose tape. No peeling of the ferromagnetic thin film layer occurred in the test.

**Claims**

1. A process for producing a magnetic recording medium by ion-plating a non-magnetic substrate (5) with ions of a ferromagnetic material (17) obtained by heating an open crucible (11) containing the ferromagnetic material (17) in a high vacuum (2) thereby vaporizing the ferromagnetic material (17), ionizing the vapour particles by impinging accelerated electrons from an electron radiation source (14) onto the vapour particles and impinging the ionized vapour particles onto the substrate (5) to form a ferromagnetic thin film thereon, characterised by employing a pressure of $1.33 \times 10^{-3}$ to $1.33 \times 10^{-4}$ Pa ($1 \times 10^{-5}$ to $1 \times 10^{-6}$ torr), ionizing the vapour particles by impinging onto them electrons from a heated filament (14), which electrons have been accelerated by applying a negative DC voltage to said filament (14) and a guard (16) and grounding a mesh electrode (15), accelerating the resulting ionized vapour particles in an electric field formed by applying a negative DC voltage to an ion-accelerating electrode (8) positioned behind the substrate (5) and impinging the accelerated ionized vapour particles onto the substrate (5) at an angle of incidence of above 30° with respect to the perpendicular to the substrate (5).

2. A process according to claim 1 wherein the ferromagnetic material (17) comprises cobalt.

3. A process according to claim 1 or 2 wherein the ferromagnetic material (17) is vaporised by impinging accelerated electrons both onto the crucible (11) having electric conductivity and onto the ferromagnetic material (17).

4. A process according to claim 1, 2 or 3, wherein the vapour particles of the ferromagnetic material (17) are ionized by an electron current of at least 30 mA released from the electron radiation source (14).

5. A process according to claim 3 wherein the conductive crucible (11) is grounded.

6. A process according to any one of claims 1 to 5 wherein the substrate (5) is a polyethylene terephthalate film.


## Patentansprüche

1. Verfahren zur Herstellung eines magnetischen Aufzeichnungsmediums durch Ionenplattierung eines nichtmagnetischen Substrat (5) mit Ionen eines ferromagnetischen Materials (17) enhalten durch Erhitzen eines offenen Tiegels (11), in welchem sich das ferromagnetische Material (17) befindet, im Hochvakuum (2) unter Verdampfen des ferromagnetischen Materials (17), Ionisieren des Dampfes durch Einwirkung schneller Elektronen aus einer Elektronenstrahlquelle (14) und von ionisiertem Dampf auf das Substrat (5) unter Bildung einer ferromagnetischen Dünnschicht, dadurch gekennzeichnet, daß man einen Druck von $1,33 \cdot 10^{-3}$ bis $1,33 \cdot 10^{-4}$ Pa ($1 \cdot 10^{-5}$ bis $1 \cdot 10^{-6}$ Torr) einhält, den Dampf ionisiert durch Einwirkung von Elektronen aus einem Heizdraht (14) auf ihn welche beschleunigt worden sind durch Anlegung einer negativen Gleichspannung an den Heizdraht (14) und ein Schutzblech (16) und Erden einer Netzelektrode (15) woraufhin der ionisierte Dampf in einem elektrischen Feld beschleunigt wird, welches durch Anlegen einer negativen Gleichspannung an eine Ionenbeschleunigende Elektrode (8) hinter dem Substrat (5) erhalten wird, und der beschleunigte Dampf in einem Einfallwinkel>30° zur Senkrechten des Substrats (5) auf dieses gerichtet wird.

2. Verfahren nach Anspruch 1, wobei das ferromagnetische Material (17) Cobalt enthält.

3. Verfahren nach Anspruch 1 oder 2, worin das ferromagnetische Material (17) verdampft wird durch Einwirkung beschleunigter Elektroden sowohl auf den elektrisch leitenden Tiegel (11) als auch das ferromagnetische Material (17).

4. Verfahren nach einem der Ansprüche 1 bis 3, wobei der Dampf des ferromagnetischen Materials (17) ionisiert wird durch einen Elektronenstrom von mindestens 30 mA aus der Elektronenstrahlquelle (14).

5. Verfahren nach Anspruch 3, wobei der leitende Tiegel (11) geerdet ist.

6. Verfahren nach einem der Ansprüche 1 bis 5, worin das Substrat (5) ein Polyethylenterephthalatfilm ist.


## Revendications

1. Procédé pour fabriquer un support d'enregistrement magnétique par métallisation ionique d'un substrat (5) à l'aide d'ions d'une matière ferromagnétique (17) que l'on obtient en chauffant un creuset ouvert (11) contenant la matière ferromagnétique (17) sous un vide élevé (2) de manière à vaporiser ainsi la matière ferromagnétique (17), en ionisant les particules de vapeur par projection d'électrons accélérés en provenance d'une source (14) d'irradiation d'électrons sur les particules de vapeur et en projetant les particules de vapeur ionisées sur le substrat (5) pour former sur celui-ci une mince pellicule ferromagnétique, caractérisée par le fait que l'on utilise une pression de $1,33 \times 10^{-3}$ à $1,33 \times 10^{-4}$ Pa ($1 \times 10^{-5}$ à $1 \times 10^{-6}$ Torr), on ionise les particules de vapeur en projetant sur celles-ci des électrons provenant d'un filament chauffé (14), ces électrons ayant été accélérés par application d'une tension continue négative audit filament (14) et à un élément de protection (16), et par mise à la masse d'une électrode de grille (15), on accélère les particules de vapeur ionisées résultantes dans un champ électrique formé par application d'une tension continue négative à une électrode (8) d'accélération d'ions disposée derrière le substrat (5), et on projette les particules de vapeur ionisées accélérées sur le substrat (5) sous un angle d'incidence supérieur à 30° par rapport à la perpendiculaire au substrat (5).

2. Procédé selon la revendication 1, dans lequel la matière ferromagnétique (17) comprend du cobalt.

3. Procédé selon la revendication 1 ou 2 dans lequel on vaporise la matière ferromagnétique (17) en projetant des électrons accélérés à la fois sur le creuset (11) doué de conductivité électrique et sur la matière ferromagnétique (17).

4. Procédé selon la revendication 1, 2 ou 3, dans lequel on ionise les particules de vapeur de la matière ferromagnétique (17) à l'aide d'un courant électronique d'au moins 30 mA libérés par la source (14) d'irradiation d'électrons.

5. Procédé selon la revendication 3, dans lequel on met à la masse le creuset conducteur (11).

6. Procédé selon l'une quelconque des revendications 1 à 5 dans lequel le substrat (5) est un film de téréphtalate de polyéthylène.

7